# FASCICULE DE BREVET EUROPEEN

(11) **EP 0 545 221 B1**
(45) Date de publication et mention de la délivrance du brevet: **05.07.1995**
(21) Numéro de dépôt: 92119969.1
(22) Date de dépôt: 24.11.1992
(51) Int. Cl.: C04B 35/00, C04B 35/64

(54) **Procédé de traitement d'une piece de céramique supraconductrice de type (Ln)1Ba2Cu307-8**
Verfahren zur Behandlung einer supraleitenden Keramik des Typs (Ln)1Ba2Cu30(7-8)
Process for the treatment of a superconducting ceramic article of the type (Ln)1Ba2Cu30(7-8)

(30) Priorité: 29.11.1991 FR 9114805
(43) Date de publication de la demande: 09.06.1993
(73) Titulaire: ALCATEL ALSTHOM COMPAGNIE GENERALE D'ELECTRICITE, 75382 Paris Cédex 08 (FR)
(72) Inventeur: Wicker, Alain, F-75013 Paris (FR); Bonnet, Jean-Pierre, F-33360 Carignan (FR); Sanz, Mariano, F-33850 Leognan (FR); Dordor, Patrice, F-33000 Bordeaux (FR); Magro, Christophe, F-33000 Bordeaux (FR)
(74) Mandataire: Weinmiller, Jürgen

(56) Documents cités:
- EP-A- 0 284 189
- PATENT ABSTRACTS OF JAPAN vol. 014, No. 270 (C-727) 12 Juin 1990
- World Patents Index Latest, Week 8938, Derwent Publications Ltd., London, GB; AN 89-274998(38)

## Description

La présente invention concerne un procédé de traitement d'une pièce en céramique supraconductrice de type (Ln)₁Ba₂Cu₃0_{7-δ} où Ln est choisi parmi l'ensemble des terres rares à l'exception du cérium et du terbium, et se rapporte en particulier à un procédé d'oxydation.

Actuellement on réoxyde la pièce en céramique frittée par traitement sous oxygène à basse température (environ 450°C), ou on refroidit la pièce très lentement sous oxygène juste après le frittage.

L'article de N.Mc.N Alford et al paru dans Nature vol 332, 3, March 1988 pages 58-59, indique en effet que la densité de courant susceptible de traverser une pièce en céramique, telle que YBa₂Cu₃0_{7-δ}, dépend fortement de la teneur en oxygène; les auteurs préconisent de rendre δ le plus proche possible de zéro.

L'article de T.B. Lindemer et al paru dans le J. Am.Ceram.Soc. 72 (10) 1775 - 88 (1989) précise les relations entre δ et divers paramètres du traitement, tels que la température et la pression partielle d'oxygène dans l'atmosphère utilisée. Il semble possible d'atteindre des valeurs de δ inférieures ou égale à 0,01, avec un traitement, sous oxygène pour des températures inférieures à 400°C, si l'on atteint l'équilibre thermodynamique; mais cet équilibre ne peut être atteint qu'après un temps très long.

La publication de J.M. Heintz et al dans J. Less Common Metals 164-165 (1990) p. 337, montre qu'il existe des barrières de diffusion aux interfaces entre les grains de la céramique, ce qui ralentit considérablement les vitesses d'oxydation. Les auteurs proposent d'augmenter la cinétique et la diffusion en augmentant la température. Mais, sous oxygène pur à 500°C, on obtient alors des valeurs de δ supérieures ou égale à 0,03.

La présente invention a pour but de proposer un traitement qui permette d'activer la diffusion de l'oxygène et de réduire la valeur de δ avec une durée de traitement raisonnable.

La présente invention a pour objet un procédé de traitement d'une pièce en céramique supraconductrice de type (Ln)₁Ba₂Cu₃0_{7-δ}, où Ln est choisi parmi l'ensemble des terres rares à l'exception du cérium et du terbium, procédé destiné à réduire la valeur de δ, selon lequel on effectue un traitement thermique de ladite pièce sous atmosphère oxydante, caractérisé par le fait que, pendant ledit traitement, l'on fait passer dans ladite pièce un courant électrique avec une densité comprise entre 0,1 et 2A/cm², ladite atmosphère de traitement présentant une pression partielle d'oxygène comprise entre 10 et 100 KPa (0,1 et 1 atmosphère), la température de traitement étant comprise entre 200°C et 500°C, la durée dudit traitement étant comprise entre 1 heure et 200 heures.

De préférence ladite température est comprise entre 350°C et 450°C et ladite durée est comprise entre 12 heures et 48 heures.

Ln est avantageusement l'yttrium.

D'autres caractéristiques et avantages de la présente invention apparaîtront au cours de la description suivante de modes de réalisation donnés à titre illustratif.

### Exemple 1

On mélange en poudre Y₁Ba₂Cu₃0_{7-δ},Y₂Ba₁Cu₁0₅ (5% molaire) et CuO(5% molaire).

On comprime à froid ce mélange et on porte le comprimé à 1195°C pendant 10 minutes, puis on refroidit rapidement jusqu'à 1040°C. On effectue alors un refroidissement lent jusqu'à la température ambiante, le tout sous oxygène pur.

On découpe un échantillon parallélépipédique de dimensions 8x2,5x15 mm. On effectue une analyse de la teneur en oxygène par mise en solution d'un petit fragment de cet échantillon et dosage de la teneur en ion Cu³⁺. On trouve δ = 35.10⁻³ et Tc = 91,6 K (mesure de suceptibilité magnétique).

L'échantillon restant est muni de contacts électriques à base de laque de platine cuite à 900°C sous oxygène. Selon l'invention on soumet cet échantillon à un traitement thermique de 25 heures à 450°C sous oxygène en appliquant un courant continu de 100 mA (soit environ 0,5A/cm²). On effectue ensuite, comme précédemment, une mesure de δ et on trouve δ = 13.10⁻³ et Tc = 92,4K.

### Exemple 2

On mélange sous forme de poudre Y₁Ba₂Cu₃0_{7-δ} et CuO (5% molaire). On réalise le même cycle que dans l'exemple 1 pour obtenir un échantillon parallélépipédique. On effectue sur celui-ci un traitement thermique sous oxygène de 30 h à 400°C; on trouve δ = 25.10⁻³ et Tc = 91,7K. Après mise en place de contacts électriques (comme dans l'exemple 1), on applique selon l'invention un courant alternatif 50HZ de 100 mA (environ 0,5A/cm²) pendant 30 h à 400°C sous une pression partielle d'oxygène de 20 KPa (0,2 atm). On trouve δ = 15.10⁻³ et Tc = 92,1 K.

Bien entendu l'invention n'est pas limitée aux exemples qui viennent d'être décrits. En particulier l'yttrium peut être remplacé par une autre terre rare, à l'exception du cérium et du terbium.

## Revendications

1. Procédé de traitement d'une pièce en céramique supraconductrice de type (Ln)₁Ba₂Cu₃0_{7-δ}, où Ln est choisi parmi l'ensemble des terres rares à l'exception du cérium et du terbium, procédé destiné à réduire la valeur de δ, selon lequel on effectue un traitement thermique de ladite pièce sous atmosphère oxydante, caractérisé par le fait que, pendant ledit traitement, on fait passer dans ladite pièce un courant électrique avec une densité comprise entre 0,1 et 2A/cm², ladite atmosphère de traitement présentant une pression partielle d'oxygène comprise entre 10 et 100 KPa (0,1 et 1 atmosphère), la température du traitement étant comprise entre 200°C et 500°C, la durée dudit traitement étant comprise entre 1 heure et 200 heures.

2. Procédé selon la revendication 1, caractérisé par le fait que Ln est l'yttrium.

3. Procédé selon l'une des revendications 1 et 2, caractérisé par le fait que ladite température est comprise entre 350°C et 450°C.

4. Procédé selon l'une des revendications précédentes, caractérisé par le fait que ladite durée est comprise entre 12 heures et 48 heures.

## Claims

1. A method of treating a part made of a superconductive ceramic of the (Ln)¹Ba₂Cu₃O_{7-δ} type, where Ln is chosen from the rare earth elements other than cerium and terbium, the method being designed to reduce the value of δ, in which method said part is heat treated in an oxidizing atmosphere, said method being characterized by the fact that, during said treatment, an electric current with a density lying in the range 0.1 A/cm² to 2 A/cm² is caused to flow through said part, said treatment atmosphere having a partial pressure of oxygen lying in the range 10 kPa and 100 kPa (0.1 atmospheres to 1 atmosphere), the treatment temperature lying in the range 200°C to 500°C, and the duration of said treatment lying in the range 1 hour to 200 hours.

2. A method according to claim 1, characterized by the fact that Ln is yttrium.

3. A method according to claim 1 or 2, characterized by the fact that said temperature lies in the range 350°C to 450°C.

4. A method according to any preceding claim, characterized by the fact that said duration lies in the range 12 hours to 48 hours.

## Patentansprüche

1. Verfahren zur Behandlung eines Bauteils aus supraleitendem Keramikmaterial der Art (Ln)₁Ba₂Cu₃O_{7-δ}, wobei Ln aus der Gesamtheit der seltenen Erden mit Ausnahme von Cer und Terbium ausgewählt wird und wobei im Rahmen des Verfahrens zur Verringerung des Werts von δ eine Wärmebehandlung des Bauteils unter oxidierender Atmosphäre erfolgt, dadurch gekennzeichnet, daß während der Behandlung in das Bauteil ein elektrischer Strom mit einer Stromdichte von zwischen 0,1 und 2A/cm² eingespeist wird, wobei die Behandlungsatmosphäre einen Sauerstoffpartialdruck zwischen 10 und 100 kPa (0,1 und 1 Atmosphäre) aufweist, die Behandlungstemperatur zwischen 200°C und 500°C und die Dauer der Behandlung zwischen 1 Stunde und 200 Stunden liegt.

2. Verfahren nach Anspruch 1, dadurch gekennzeichnet, daß Ln Yttrium ist.

3. Verfahren nach einem der Ansprüche 1 und 2, dadurch gekennzeichnet, daß die Temperatur zwischen 350°C und 450° liegt.

4. Verfahren nach einem der vorhergehenden Ansprüche, dadurch gekennzeichnet, daß die Dauer zwischen 12 Stunden und 48 Stunden liegt.
